# FASCICULE DE BREVET EUROPEEN

(11) **EP 3 749 969 B1**
(45) Date de publication et mention de la délivrance du brevet: **17.05.2023**
(21) Numéro de dépôt: 19705771.4
(22) Date de dépôt: 22.02.2019
(51) Int. Cl.: H01R 24/52, G01R 31/28

(54) **EQUIPEMENT ELECTRIQUE COMPORTANT UNE PREMIERE PARTIE ET UNE DEUXIEME PARTIE ISOLEE ELECTRIQUEMENT DE LA PREMIERE PARTIE**
ELEKTRISCHES GERÄT MIT EINEM ERSTEN ABSCHNITT UND EINEM ZWEITEN ABSCHNITT, DER GEGENÜBER DEM ERSTEN ABSCHNITT ELEKTRISCH ISOLIERT IST
ELECTRICAL EQUIPMENT COMPRISING A FIRST PORTION AND A SECOND PORTION THAT IS ELECTRICALLY INSULATED FROM THE FIRST PORTION

(30) Priorité: 22.02.2018 FR 1851513
(43) Date de publication de la demande: 16.12.2020
(73) Titulaire: Sagemcom Energy & Telecom SAS, 92500 Rueil-Malmaison (FR)
(72) Inventeur: TEBOULLE, Henri, 92500 RUEIL MALMAISON (FR); KHOURI, Rami, 92500 RUEIL MALMAISON (FR)
(74) Mandataire: Lavaud, Thomas
(86) Numéro de dépôt international: PCT/EP2019/054426
(87) Numéro de publication internationale: WO 2019/162432

(56) Documents cités:
- US-A- 5 222 164
- US-A- 5 621 256
- US-A1- 2003 002 808
- US-A1- 2009 047 841
- US-A1- 2009 286 427
- US-A1- 2011 230 073
- US-A1- 2015 276 454

## Description

L'invention concerne le domaine des équipements électriques comportant une première partie et une deuxième partie isolée électriquement de la première partie.

### ARRIERE PLAN DE L'INVENTION

Certains compteurs modernes, par exemple des compteurs d'énergie électrique, d'eau ou de gaz, sont équipés d'un module de communication radiofréquence. Grâce à ce module de communication radiofréquence, un compteur peut communiquer soit directement soit via un concentrateur de données avec un fournisseur d'énergie électrique, d'eau ou de gaz, ou bien avec un distributeur ou un gestionnaire de réseau.

Les données transmises ou reçues par un tel compteur sont par exemple des données relatives à la consommation d'énergie électrique, d'eau ou de gaz, à une tarification, à un abonnement, à une surveillance du compteur, à un ordre d'ouverture ou de fermeture d'un organe de coupure du compteur dans le cas d'un compteur d'énergie électrique, etc.

Le module de communication radiofréquence d'un tel compteur est alors relié à une antenne interne située à l'intérieur d'un boîtier du compteur. Parfois, et notamment lorsque le compteur se trouve dans une zone géographique isolée ou éloignée du concentrateur de données le plus proche, les communications radiofréquences sont difficiles et il est avantageux de connecter au compteur une antenne externe qui améliore l'émission et la réception des données.

L'utilisation d'une antenne externe ne pose pas de problème lorsque les tensions électriques à l'intérieur du compteur sont relativement basses. On parle parfois de TBTS (pour « Très Basse Tension de Sécurité ») pour désigner de telles tensions.

Cependant, la situation est plus problématique lorsque les tensions électriques à l'intérieur du compteur peuvent être élevées. On parle parfois de TRT (pour « Tension de Réseau de Télécommunication ») pour désigner de telles tensions.

En effet, dans ce cas, il convient, pour que le compteur soit conforme aux normes électriques usuelles, d'assurer que l'antenne externe et son câble de connexion au compteur soient isolés électriquement de l'intérieur du compteur. Cette exigence d'isolation électrique complexifie la conception de l'interface électrique entre l'antenne externe et le compteur, mais aussi la conception de la fonction de commutation entre l'antenne interne et l'antenne externe.

Des exemples de l'art antérieur de détection de la présence d'une fiche dans un réceptacle peuvent être vus en US 5 621 256 A, US 2003/002808 A1, US 5 222 164 A, US 2011/230073 A1, US 2009/047841 A1 et US 2015/276454 A1.

### OBJET DE L'INVENTION

L'invention a pour objet de résoudre le problème qui vient d'être décrit.

### RESUME DE L'INVENTION

En vue de la réalisation de ce but, on propose un équipement électrique comportant une première partie et une deuxième partie isolée électriquement de la première partie, la première partie comprenant un composant frontal, une diode, une photodiode et un module de traitement, la deuxième partie comprenant un premier connecteur connecté au composant frontal tout en étant isolé électriquement de celui-ci, un espace d'accueil s'étendant en regard du premier connecteur et étant agencé pour accueillir un deuxième connecteur pouvant être connecté au premier connecteur, la diode électroluminescente et la photodiode étant disposées de part et d'autre de l'espace d'accueil, le module de traitement étant agencé pour fournir un courant d'alimentation à la diode électroluminescente de sorte que celle-ci produise un signal lumineux émis, pour acquérir un signal électrique de détection produit par la photodiode et représentatif d'un signal lumineux reçu par la photodiode, et pour détecter une présence ou une absence du deuxième connecteur dans l'espace d'accueil en fonction du signal électrique de détection.

Il est possible que des tensions électriques élevées soient présentes dans la première partie de l'équipement électrique. Lorsqu'un opérateur ou un utilisateur connecte une antenne externe à l'équipement électrique, ladite antenne externe étant reliée via un câble au deuxième connecteur, il connecte le deuxième connecteur au premier connecteur de la deuxième partie de l'équipement électrique, qui est isolée électriquement de la première partie.

Ainsi, les tensions électriques élevées ne peuvent être présentes dans la deuxième partie, et la manipulation de l'antenne externe et du câble par l'opérateur ou l'utilisateur peut être effectuée sans risque.

La diode électroluminescente et la photodiode permettent de détecter la présence du deuxième connecteur, lorsque le signal lumineux est interrompu par le connecteur ou son câble, et donc, dans le cas ci-dessus, de détecter la connexion de l'antenne externe à l'équipement électrique. Cette détection permet de gérer efficacement une éventuelle commutation entre une antenne interne de l'équipement électrique et l'antenne externe. La diode électroluminescente et la photodiode, qui peuvent être soumises à des tensions électriques élevées, sont isolées de la deuxième partie. La détection est donc réalisée sans risque pour l'opérateur ou l'utilisateur manipulant l'antenne externe ou le câble.

On propose aussi un équipement électrique tel que celui qui vient d'être décrit, comportant en outre une antenne interne, un module de communication radiofréquence et un composant de commutation situés dans la première partie, le composant de commutation ayant une entrée reliée au module de communication radiofréquence, une première sortie reliée à l'antenne interne et une deuxième sortie connectée au premier connecteur, le module de traitement étant agencé pour connecter l'entrée à la première sortie lorsque l'absence du deuxième connecteur dans l'espace d'accueil est détectée, et pour connecter l'entrée à la deuxième sortie lorsque la présence du deuxième connecteur dans l'espace d'accueil est détectée.

On propose en outre un procédé de configuration mis en œuvre dans un équipement électrique tel que celui qui vient d'être décrit, le procédé de configuration comportant les étapes de :
- émettre le signal lumineux émis ;
- acquérir le signal électrique de détection ;
- si une absence du deuxième connecteur est détectée, connecter l'entrée du composant de commutation à la première sortie du composant de commutation ;
- si une présence du deuxième connecteur est détectée, connecter l'entrée du composant de commutation à la deuxième sortie du composant de commutation.

On propose de plus un programme d'ordinateur comprenant des instructions pour mettre en oeuvre, par un microcontrôleur d'un équipement électrique, le procédé de configuration qui vient d'être décrit.

On propose en outre des moyens de stockage, caractérisés en ce qu'ils stockent un programme d'ordinateur comprenant des instructions pour mettre en oeuvre, par un microcontrôleur d'un équipement électrique, le procédé de configuration qui vient d'être décrit.

D'autres caractéristiques et avantages de l'invention ressortiront à la lecture de la description qui suit d'un mode de réalisation particulier, non limitatif de l'invention.

### BREVE DESCRIPTION DES DESSINS

Il sera fait référence aux dessins annexés parmi lesquels :
- la figure 1 représente une vue en perspective et de dessous d'un équipement électrique selon l'invention, l'équipement électrique étant un compteur d'énergie électrique ;
- la figure 2 représente un schéma électrique du compteur.

### DESCRIPTION DETAILLEE DE L'INVENTION

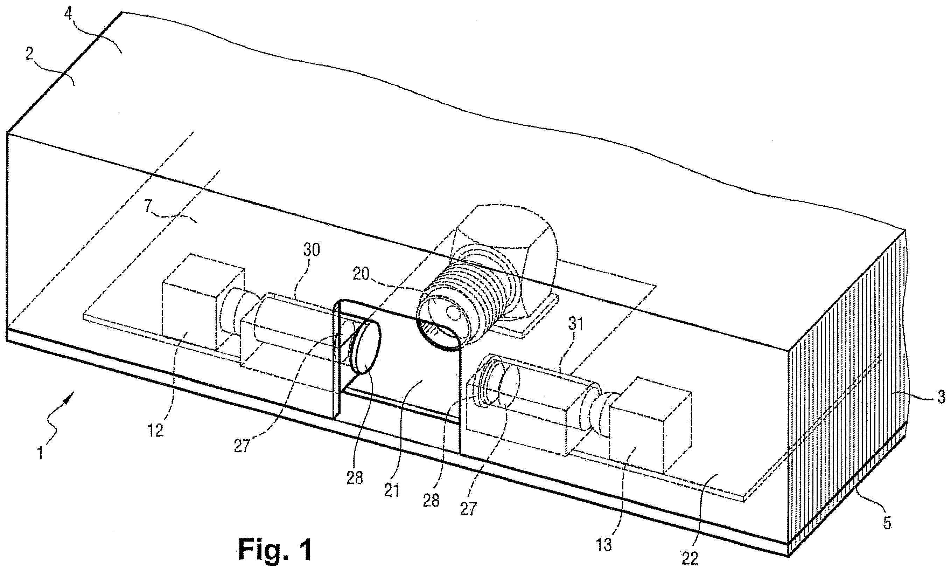

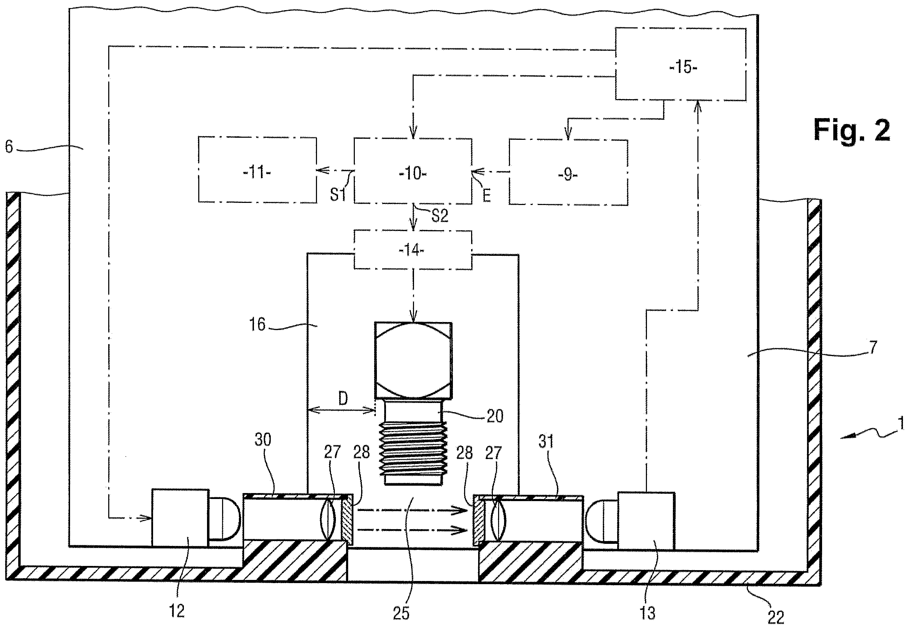

En référence aux figures 1 et 2, l'équipement électrique selon l'invention est ici un compteur d'énergie électrique 1.

Le compteur 1 comporte un boîtier 2 comprenant un coffret 3, un capot 4 et un couvre-borne (absent sur la figure 1). Une face arrière 5 du coffret 3 est destinée à être fixée à un mur d'une habitation ou d'un bâtiment quelconque. Lorsque le compteur 1 est opérationnel, le capot 4 est scellé sur le coffret 3, et le couvre-borne est scellé sur le capot 4. Le scellage du capot sur le coffret est ici réalisé par bouterollage. Ainsi, lorsque le compteur 1 est opérationnel, tout accès à l'intérieur du compteur 1 par une personne non habilitée est détecté et peut être sanctionné.

Le compteur 1 comporte une première partie et une deuxième partie isolée électriquement de la première partie.

La première partie du compteur 1 comprend une première portion 6 d'une carte électrique 7. La carte électrique 7 comprend un circuit imprimé. Le circuit imprimé s'étend à l'intérieur du boîtier 2 parallèlement à la face arrière 5 du coffret 3.

La première partie du compteur 1 comprend des composants électriques et optroniques montés sur la première portion 6 de la carte électrique 7.

Les composants électriques et optroniques comprennent ici un module de traitement, un module de communication radiofréquence 9, un composant de commutation, une antenne interne 11, une diode électroluminescente 12, une photodiode 13 et une première partie d'un coupleur radiofréquence 14.

Le module de traitement comporte un composant de traitement. Le composant de traitement est adapté à exécuter des instructions d'un programme pour réaliser les tâches qui lui sont dédiées. Le composant de traitement est ici un microcontrôleur 15, mais pourrait être un composant différent, par exemple un processeur ou un FPGA.

Le microcontrôleur 15 est agencé pour piloter le module de communication radiofréquence 9 et le composant de commutation. Le microcontrôleur 15 est aussi agencé pour fournir un courant d'alimentation à la diode électroluminescente 12 de sorte que celle-ci produise un signal lumineux émis, et pour acquérir un signal électrique de détection produit par la photodiode 13.

Le module de communication radiofréquence 9 comprend un émetteur et un récepteur. L'émetteur transforme un signal de données sortant, produit par le microcontrôleur 15, en un signal radiofréquence sortant adapté à être appliqué en entrée de l'antenne interne 11 (et de l'antenne externe qui sera évoquée plus bas) pour être émis par l'antenne interne 11 (ou par l'antenne externe). Le récepteur transforme un signal radiofréquence entrant reçu par l'antenne interne 11 (ou par l'antenne externe) et le transforme en un signal de données entrant adapté à être reçu par le microcontrôleur 15.

Le composant de commutation est un interrupteur radiofréquence 10 comprenant une entrée E reliée au module de communication radiofréquence 9, une première sortie S1 reliée à l'antenne interne 11 et une deuxième sortie S2 reliée à la première partie du coupleur radiofréquence 14.

L'antenne interne 11 est ici imprimée sur le circuit imprimé de la carte électrique 7.

Le coupleur radiofréquence 14 comporte une première partie et une deuxième parties isolées électriquement l'une de l'autre. La première partie du coupleur radiofréquence 14 est incluse dans la première partie du compteur 1 et est reliée à la deuxième sortie S2 de l'interrupteur radiofréquence 10, alors que la deuxième partie du coupleur radiofréquence 14 est incluse dans la deuxième partie du compteur 1.

La diode électroluminescente 12 est agencée pour générer des signaux lumineux émis dans le domaine de l'infrarouge. On choisit avantageusement une longueur d'onde ne se situant pas dans le spectre visible par l'oeil humain. Ainsi, les signaux lumineux émis n'attirent pas l'attention d'un utilisateur. On utilise donc ici une diode électroluminescente 12 qui génère des signaux lumineux émis dont le spectre est compris dans l'infrarouge proche, c'est à dire qui présentent une longueur d'onde typiquement comprise entre 850nm et 1000nm.

On choisit par ailleurs une diode électroluminescente 12 relativement directive, qui présente un angle d'ouverture aussi faible que possible, typiquement inférieur à +/-30° (c'est à dire que l'angle d'ouverture total est inférieur à 60°). On choisit aussi la diode électroluminescente 12 en tenant compte des conditions environnementales d'utilisation, et notamment en fonction d'une gamme de température susceptible de régner dans le compteur 1 à l'endroit où est positionnée la diode électroluminescente 12. La diode électroluminescente 12 est ici un composant du type « monté en surface », avec une orientation de 90°, c'est à dire qu'une zone d'émission de la diode électroluminescente 12 s'étend verticalement par rapport au circuit imprimé de la carte électrique 7.

On choisit par exemple, pour la diode électroluminescente 12, la référence SFH 4045N du fabricant de composants OSRAM.

La photodiode 13, quant à elle, est sensible aux signaux lumineux émis générés par la diode électroluminescente 12. Lorsque la photodiode 13 reçoit un signal lumineux reçu issu d'un signal lumineux émis généré par la diode électroluminescente 12, la photodiode 13 produit un signal électrique de détection représentatif du signal lumineux reçu.

On choisit par exemple, pour la photodiode 13, la référence SFH 325 FA du fabricant OSRAM.

On décrit maintenant la deuxième partie du compteur 1, isolée électriquement de la première partie.

La deuxième partie du compteur 1 comporte une deuxième portion 16 de la carte électrique 7, isolée électriquement de la première portion 6 de la carte électrique 7. La deuxième portion 16 présente une surface rectangulaire, inférieure à celle de la première portion 6, et s'étend à l'intérieur de la première portion 6 perpendiculairement à un bord du circuit imprimé.

La deuxième partie du compteur 1 comprend la deuxième partie du coupleur radiofréquence 14, isolée de la première partie du coupleur radiofréquence 14, ainsi qu'un premier connecteur 20. La deuxième partie du coupleur radiofréquence 14 et le premier connecteur 20 sont montés sur la deuxième portion 16 de la carte électrique 7.

Une cavité 21 est pratiquée dans le capot 4 du boîtier 2 du compteur 1. L'entrée de la cavité 21 est située sur une face inférieure 22 du capot 4. La cavité 21 s'étend à l'intérieur du capot 4 depuis la face inférieure 22 du capot 4, perpendiculairement à la face inférieure 22 du capot 4.

Le premier connecteur 20 est positionné dans la cavité 21.

Le premier connecteur 20 est connecté, au niveau d'une partie arrière du premier connecteur 20, à la deuxième partie du coupleur radiofréquence 14. Le premier connecteur 20 est ainsi connecté à un composant frontal de la première partie du compteur 1, qui est en l'occurrence l'interrupteur radiofréquence 10, via le coupleur radiofréquence 14.

Le premier connecteur 20 est ici un connecteur SMA. On choisit, pour le premier connecteur 20, la référence R125680000W du fabricant RADIALL.

Un espace d'accueil 25, défini dans la cavité 21, s'étend en regard d'une partie avant du premier connecteur 20. L'espace d'accueil 25 est agencé pour accueillir un deuxième connecteur complémentaire du premier connecteur 20.

Ici, en l'occurrence, le deuxième connecteur est positionné à une première extrémité d'un câble qui comporte à sa deuxième extrémité une antenne externe.

Le deuxième connecteur peut être vissé sur le premier connecteur 20 et en être dévissé, soit manuellement, soit à l'aide d'un outil tel qu'une clé dynamométrique pour connecteur SMA.

Ces opérations de vissage et de dévissage peuvent être réalisées alors que le capot 4 est monté sur le coffret 3 du boîtier 2, à condition que le couvre-borne ne soit pas présent. Ces opérations de vissage et de dévissage sont généralement réalisées au cours de l'installation du compteur 1. Une fois que ces opérations ont été réalisées, le couvre-borne est monté puis scellé sur le capot 4.

Un premier conduit 30 et un deuxième conduit 31 sont définis dans le capot 4 du boîtier 2 du compteur 1. Le premier conduit 30 et le deuxième conduit 31 appartiennent à la deuxième partie du compteur 1.

Le premier conduit 30 et le deuxième conduit 31 s'étendent chacun parallèlement à la face inférieure 22 du capot 4, et débouchent chacun au niveau d'une première extrémité dans la première partie du compteur 1, et au niveau d'une deuxième extrémité dans l'espace d'accueil 25 de la cavité 21, à proximité de l'entrée de la cavité 21. Le premier conduit 30 et le deuxième conduit 31 sont coaxiaux et sont positionnés de chaque côté de la cavité 21.

Le premier conduit 30 et le deuxième conduit 31 sont des tunnels définis dans une pièce unique formant le capot 4. Le premier conduit 30 et le deuxième conduit 31 présentent ici une forme cylindrique dont la section est un disque.

Le premier conduit 30 et le deuxième conduit 31 s'étendent chacun partiellement au-dessus de la première portion 6, et partiellement au-dessus de la deuxième portion 16 de la carte électrique 7 lorsque la carte électrique 7 est positionnée dans le boîtier 2 et que le capot 4 est monté sur le coffret 3.

Le capot 4, le premier conduit 30 et le deuxième conduit 31 sont fabriqués par moulage en étant issus d'un même moule. Le moule comporte en l'occurrence des tiroirs amovibles, qui sont maintenus dans le moule lorsqu'un capot ne nécessitant pas de conduit est fabriqué, et qui sont retirés du moule lorsqu'un capot nécessitant les conduits est fabriqué. On réduit ainsi de manière non négligeable le coût série de fabrication des capots, puisqu'un même moule peut être utilisé pour fabriquer deux références de capot différentes.

La diode électroluminescente 12 est positionnée au niveau de la première extrémité du premier conduit 30. La photodiode 13 est positionnée au niveau de la première extrémité du deuxième conduit 31. La diode électroluminescente 12 et la photodiode 13 sont donc positionnées en regard l'une de l'autre, de part et d'autre de l'espace d'accueil 25.

Le premier conduit 30 et le deuxième conduit 31 forment ainsi des guides d'ondes pour les signaux lumineux émis par la diode électroluminescente 12 et pour les signaux lumineux reçus par la photodiode 13 et résultant des signaux lumineux émis.

Une lentille convergente 27 est ici située à l'intérieur de chacun des premier conduit 30 et deuxième conduit 31, à proximité de la deuxième extrémité de chacun des premier conduit 30 et deuxième conduit 31.

Les lentilles convergentes 27 permettent de guider encore plus efficacement les signaux lumineux émis par la diode électroluminescente 12 vers la photodiode 13.

Tout type de lentille convergente peut être utilisé : biconvexe, plan-convexe, etc.

Un bouchon en plastique transparent 28 est positionnée au niveau de la deuxième extrémité de chacun des premier conduit 30 et deuxième conduit 31. Les bouchons en plastique transparent 28 permettent d'éviter une pénétration de poussière à l'intérieur du compteur 1 via le premier conduit 30 ou le deuxième conduit 31.

La diode électroluminescente 12 et la photodiode 13 sont utilisées de la manière suivante.

Le microcontrôleur 15 fournit à intervalles réguliers un courant d'alimentation à la diode électroluminescente 12 (éventuellement via un *driver* inclus dans le module de traitement). La diode électroluminescente 12 produit alors des signaux lumineux émis.

Lorsqu'aucune antenne externe n'est connectée au compteur 1, l'antenne qui doit être utilisée par le compteur 1 pour émettre ou recevoir des données est l'antenne interne 11 de la première partie du compteur 1.

Comme aucun deuxième connecteur n'est présent dans l'espace d'accueil 25 en face du premier connecteur 20, les signaux lumineux émis cheminent dans le premier conduit 30, dans l'espace d'accueil 25 et dans le deuxième conduit 31 sans rencontrer d'obstacle. La photodiode 13 reçoit alors des signaux lumineux reçus. La photodiode 13 produit, à partir des signaux lumineux reçus, un signal électrique de détection représentatif des signaux lumineux reçus.

Comme les signaux lumineux émis ne rencontrent pas d'obstacle, une intensité lumineuse des signaux lumineux reçus est supérieure ou égale à un seuil d'intensité lumineuse prédéterminé, et donc une intensité ou une tension du signal électrique de détection est supérieure ou égale à un seuil électrique prédéterminé (défini à partir du seuil d'intensité lumineuse prédéterminé).

Le microcontrôleur 15 acquiert le signal électrique de détection et détecte alors une absence du deuxième connecteur dans l'espace d'accueil 25. Le microcontrôleur 15 connecte l'entrée E de l'interrupteur radiofréquence 10 à la première sortie S1 de l'interrupteur radiofréquence 10, de sorte que le module de communication radiofréquence 9 est relié à l'antenne interne 11 du compteur 1.

Au contraire, lorsqu'une antenne externe est connectée au compteur 1, l'antenne qui doit être utilisée par le compteur 1 pour émettre ou recevoir des données est l'antenne externe. Cette antenne externe est en effet conçue pour améliorer à la fois l'émission des signaux radiofréquences sortants et la réception des signaux radiofréquences entrants.

Un deuxième connecteur est alors connecté au premier connecteur 20, et est donc positionné dans l'espace d'accueil 25.

Les signaux lumineux émis par la diode électroluminescente 12 cheminent dans le premier conduit 30 mais sont bloqués par le deuxième connecteur.

La photodiode 13 reçoit alors des signaux lumineux reçus de très faible intensité lumineuse, voire d'intensité nulle. L'intensité lumineuse des signaux lumineux reçus est donc inférieure au seuil d'intensité lumineuse prédéterminé, et donc une intensité ou une tension du signal électrique de détection est inférieure au seuil électrique prédéterminé.

Le microcontrôleur 15 acquiert le signal électrique de détection et détecte alors une présence du deuxième connecteur dans l'espace d'accueil 25. Le microcontrôleur 15 connecte l'entrée E de l'interrupteur radiofréquence 10 à la deuxième sortie S2 de l'interrupteur radiofréquence 10, de sorte que le module de communication radiofréquence 9 est relié à l'antenne externe du compteur 1.

Il convient d'éviter absolument toute fausse détection d'une antenne externe. En effet, en cas de fausse détection, le microcontrôleur 15 connecterait l'entrée E de l'interrupteur radiofréquence 10, et donc le module de communication radiofréquence 9, à la deuxième sortie S2 de l'interrupteur radiofréquence 10, qui ne serait pas connectée à une antenne externe. Le module de communication radiofréquence 9 ne serait alors connecté à aucune antenne, ce qui empêcherait le compteur 1 de communiquer via une communication radiofréquence.

On choisit donc un seuil d'intensité lumineuse prédéterminé relativement bas, et donc un seuil électrique prédéterminé relativement bas, pour éviter tout risque de fausse détection d'une antenne externe.

Pour sécuriser la détection et éviter toute fausse détection, on introduira dans les signaux lumineux émis une signature (c'est à dire une caractéristique distinctive des signaux), permettant de distinguer les signaux lumineux émis par la diode électroluminescente 12 du compteur 1 d'un signal lumineux parasite pouvant être émis par une source externe au compteur 1 (intentionnellement ou non).

Cette caractéristique distinctive consiste ici à hacher les signaux lumineux émis. Le courant d'alimentation fourni par le microcontrôleur 15 à la diode électroluminescente 12 est tel que celle-ci émet les signaux lumineux émis pendant une première durée prédéterminée et n'émet pas pendant une deuxième durée prédéterminée, la première durée prédéterminée et la deuxième durée prédéterminée se faisant suite et étant répétées périodiquement. Ici, la première durée prédéterminée et la deuxième durée prédéterminée sont toutes deux égales à 0.5s, et le hachage est donc réalisé avec une fréquence de 1Hz.

On note qu'il est possible, pour optimiser la consommation électrique du compteur 1, de mettre en oeuvre ce hachage uniquement lorsqu'un signal lumineux reçu non haché a été détecté par la photodiode 13. Le hachage permet alors de confirmer que le signal lumineux reçu provient bien de la diode électroluminescente 12.

On comprend que le premier conduit et le deuxième conduit remplissent une fonction d'isolation entre la première partie du compteur 1 et l'extérieur. C'est d'ailleurs aussi le cas de la distance d'isolation D qui sépare le premier connecteur 20 des bords de la première portion 6 de la carte électrique 7.

En effet, le premier conduit 30 et le deuxième conduit 31 isolent la diode électroluminescente 12 et la photodiode 13 de l'extérieur. Comme la diode électroluminescente 12 et la photodiode 13 sont situées dans la zone potentiellement soumise à des tensions électriques élevées et dangereuses, il convient de dimensionner le premier conduit 30 et le deuxième conduit 31 pour que cette isolation soit conforme aux recommandations décrites dans les normes de sécurité applicables.

Pour pouvoir être utilisé en Europe, un compteur d'énergie électrique doit satisfaire aux exigences des directives européennes, et notamment aux normes suivantes :
- EN 61010-1 ;
- EN 62052-31 ;
- EN 62368-1 ;
- EN 50470-1.

On définit dans ces normes, en fonction de la catégorie de surtension et du degré de pollution considérés :
- des lignes de fuite ;
- des distances dans l'air ;
- des tensions de tenue diélectrique.

La conception du compteur 1 et donc les choix des différents composants, des matériaux utilisés et des interfaces mécaniques, doit permettre au compteur 1 de respecter ces normes.

Ici, il est possible que des tensions électriques très élevées et donc dangereuses soient présentes dans la première partie du compteur 1. Ces tensions électriques très élevées sont par exemple des tensions de 230V provenant du réseau électrique auquel est relié le compteur 1. Une fois le compteur 1 installé, le capot 4 étant positionné sur le coffret 3 et scellé, il faut assurer qu'un opérateur ou un utilisateur en contact avec le deuxième connecteur , avec l'antenne externe, ou avec toute autre surface du boîtier 2 du compteur 1, et donc, directement ou indirectement, avec la deuxième partie du compteur 1, reste isolé des tensions électriques élevées, et donc de la première partie du compteur 1.

On utilise, pour dimensionner les longueurs du premier conduit 30 et du deuxième conduit 31, ainsi que la distance d'isolation D, les caractéristiques des matériaux classiquement utilisés pour fabriquer le capot 4, le circuit imprimé de la carte électrique 7 (par exemple du FR4), ainsi que celles de l'air.

On a déterminé que, en fonction de ces caractéristiques et des exigences d'isolation, les longueurs du premier conduit 30 et du deuxième conduit 31, ainsi que la distance d'isolation D, doivent être chacune égales au minimum à 8mm. On assure ainsi une tenue diélectrique de 6kV en tension de choc.

On choisit de conférer à chacun des premier conduit 30 et deuxième conduit 31 une longueur supérieure à 10mm. Ainsi, chacun des premier conduit 30 et deuxième conduit 31 s'étend au-dessus de la première portion 6 de la carte électrique 7 sur une longueur telle que la diode électroluminescente 12 et la photodiode 13 peuvent être positionnées à proximité immédiate, voire à l'intérieur, de la première extrémité du premier conduit 30 et du deuxième conduit 31.

Le diamètre du premier conduit 30 et du deuxième conduit 31 est ici égal à 3mm, ce qui correspond au diamètre de la zone d'émission de la diode électroluminescente 12. Le diamètre du premier conduit 30 et du deuxième conduit 31 est inférieur à celui du câble reliant le deuxième connecteur à l'antenne externe, pour éviter tout risque de confusion au moment du montage du deuxième connecteur.

On note aussi qu'il convient que le boîtier 2 du compteur 1, couvre-borne mis en place, assure un indice de protection IP suffisant pour que la poussière et/ou l'eau ne puisse pas pénétrer dans le compteur 1, en particulier au niveau du premier connecteur 20, faute de quoi l'efficacité de la barrière d'isolation peut être dégradée.

Bien entendu, l'invention n'est pas limitée au mode de réalisation décrit, mais englobe toute variante entrant dans le champ de l'invention telle que définie par les revendications.

On a décrit ici l'utilisation d'une lentille convergente dans chacun des premier conduit et deuxième conduit. Il serait bien sûr possible de n'utiliser qu'une lentille, alors positionnée de préférence dans le premier conduit, voire même aucune lentille. Il serait également possible que la lentille soit intégrée au plastique transparent, ne formant alors qu'une seule pièce.

On a indiqué que le premier conduit et le deuxième conduit présentent une forme cylindrique dont la section est un disque. La géométrie de chaque conduit peut bien sûr être différente de celle décrite. Chaque conduit pourrait notamment présenter la forme d'un cylindre ayant une section différente, ou bien la forme d'un cylindre partiellement évidé.

On pourrait ainsi imaginer qu'un conduit (ou que les deux conduits) prenne la forme d'un cylindre évidé et ouvert pour déboucher sur la carte électrique. Un tel conduit pourrait ainsi recouvrir partiellement la diode (ou la photodiode) de sorte que la partie supérieure du guide d'onde serait alors formée par le conduit et la partie inférieure par la carte électrique.

Le premier conduit et le deuxième conduit pourraient être des pièces rapportées sur le boîtier du compteur.

On a indiqué que les conduits sont formés dans le capot du boîtier. Les conduits pourraient être formés dans tout élément de boîtier, quelle que soit sa position et son appellation : coffret, couvercle, capot supérieur ou inférieur, cache-borne, etc.

Tous les composants cités (diode électroluminescente, photodiode, connecteur, etc.) pourraient être différents et, notamment, présenter des références et des caractéristiques électriques et optiques différentes de celles fournies ici.

La première partie et la deuxième partie du compteur ne comprennent pas nécessairement une portion distincte d'une même carte électrique. La première partie et la deuxième partie du compteur pourraient comporter chacune une carte électrique distincte.

L'invention s'applique bien sûr à tout type d'équipement électrique, et peut par exemple être mise en oeuvre dans un boîtier décodeur, un téléphone mobile, une tablette, un ordinateur portable, etc.

Dans cette description, on a mis en œuvre l'invention dans un compteur d'énergie électrique. L'invention s'applique bien sûr à tout type de compteur, et notamment aux compteurs d'eau et de gaz.

L'invention s'applique à tout type d'équipement électrique comportant une première partie et une deuxième partie isolée électriquement de la première partie, et auquel on peut connecter un câble. Cet équipement électrique peut, mais pas nécessairement, comporter une antenne interne, le câble en question étant relié, mais pas nécessairement, à une antenne externe.

La mise en oeuvre de l'isolation électrique peut être dictée par une problématique de sécurité des personnes et des équipements qui se pose du fait de la présence de tensions ou de courants élevés dans l'équipement électrique, comme c'est le cas dans cette description. La mise en œuvre de l'isolation électrique peut être dictée par des exigences différentes, par exemple par une exigence de protection de données informatiques utilisées ou stockées dans l'équipement électrique, qui ne doivent pas pouvoir être accessibles ou corrompues depuis l'extérieur de l'équipement électrique. Le premier connecteur doit être alors de plus isolé de tout autre connecteur interne à l'équipement.

## Revendications

1. Equipement électrique comportant une première partie et une deuxième partie isolée électriquement de la première partie, la première partie comprenant un composant frontal (10), une diode électroluminescente (12), une photodiode (13) et un module de traitement (15), la deuxième partie comprenant un premier connecteur (20) connecté au composant frontal tout en étant isolé électriquement de celui-ci, un espace d'accueil (25) s'étendant en regard du premier connecteur et étant agencé pour accueillir un deuxième connecteur pouvant être connecté au premier connecteur, la diode électroluminescente et la photodiode étant disposées de part et d'autre de l'espace d'accueil, le module de traitement étant agencé pour fournir un courant d'alimentation à la diode électroluminescente (12) de sorte que celle-ci produise un signal lumineux émis, pour acquérir un signal électrique de détection produit par la photodiode (13) et représentatif d'un signal lumineux reçu par la photodiode, et pour détecter une présence ou une absence du deuxième connecteur dans l'espace d'accueil en fonction du signal électrique de détection.

2. Equipement électrique selon la revendication 1, dans lequel la diode électroluminescente est positionnée à une première extrémité d'un premier conduit (30), la photodiode est positionnée à une première extrémité d'un deuxième conduit (31), le premier conduit et le deuxième conduit formant des guides d'onde pour le signal lumineux émis et pour le signal lumineux reçu, chacun des premier conduit et deuxième conduit appartenant à la deuxième partie et débouchant, au niveau d'une deuxième extrémité, dans l'espace d'accueil (25).

3. Equipement électrique selon la revendication 2, dans lequel le premier conduit et le deuxième conduit sont pratiqués dans un élément de boîtier (4) de l'équipement électrique.

4. Equipement électrique selon la revendication 3, dans lequel l'élément de boîtier, le premier conduit et le deuxième conduit sont fabriqués par moulage et sont issus d'un même moule.

5. Equipement électrique selon la revendication 2, comprenant au moins une lentille convergente (27) positionnée au niveau de la deuxième extrémité du premier conduit et/ou de la deuxième extrémité du deuxième conduit.

6. Equipement électrique selon la revendication 2, dans lequel les longueurs des premier conduit et deuxième conduit sont définies pour assurer un certain niveau d'isolation électrique entre la première partie et la deuxième partie.

7. Equipement électrique selon l'une des revendications précédentes, dans lequel le signal lumineux émis comprend une signature permettant de le distinguer d'un signal lumineux parasite pouvant être émis par une source externe à l'équipement électrique.

8. Equipement électrique selon la revendication 7, dans lequel la signature consiste à hacher le signal lumineux émis.

9. Equipement électrique selon l'une des revendications précédentes, comportant en outre une antenne interne (11), un module de communication radiofréquence (9) et un composant de commutation (10) situés dans la première partie, le composant de commutation ayant une entrée (E) reliée au module de communication radiofréquence, une première sortie (S1) reliée à l'antenne interne et une deuxième sortie (S2) connectée au premier connecteur (20), le module de traitement étant agencé pour connecter l'entrée à la première sortie lorsque l'absence du deuxième connecteur dans l'espace d'accueil est détectée, et pour connecter l'entrée à la deuxième sortie lorsque la présence du deuxième connecteur dans l'espace d'accueil est détectée.

10. Equipement électrique selon l'une des revendications précédentes, l'équipement électrique étant un compteur d'énergie électrique, d'eau ou de gaz.

11. Système comportant un équipement électrique selon l'une des revendications précédentes, une antenne externe, et un câble muni à une première extrémité du deuxième connecteur relié au premier connecteur, et à une deuxième extrémité de l'antenne externe.

12. Procédé de configuration mis en oeuvre dans un équipement électrique selon la revendication 9, le procédé de configuration comportant les étapes de :
- émettre le signal lumineux émis ;
- acquérir le signal électrique de détection ;
- si une absence du deuxième connecteur est détectée, connecter l'entrée du composant de commutation à la première sortie du composant de commutation ;
- si une présence du deuxième connecteur est détectée, connecter l'entrée du composant de commutation à la deuxième sortie du composant de commutation.

13. Programme d'ordinateur comprenant des instructions pour mettre en oeuvre, par un microcontrôleur d'un équipement électrique, le procédé de configuration selon la revendication 12.

14. Moyens de stockage, **caractérisés en ce qu'**ils stockent un programme d'ordinateur comprenant des instructions pour mettre en oeuvre, par un microcontrôleur d'un équipement électrique, le procédé de configuration selon la revendication 12.

## Patentansprüche

1. Elektrisches Gerät, umfassend einen ersten Teil und einen zweiten Teil, der von dem ersten Teil elektrisch isoliert ist, wobei der erste Teil eine Front-End-Komponente (10), eine Elektrolumineszenzdiode (12), eine Photodiode (13) und ein Verarbeitungsmodul (15) umfasst, wobei der zweite Teil einen ersten Verbinder (20) umfasst, der mit der Front-End-Komponente verbunden ist, während er zu derselben elektrisch isoliert ist, wobei sich ein Aufnahmeraum (25) gegenüber dem ersten Verbinder erstreckt und ausgebildet ist, einen zweiten Verbinder aufzunehmen, der mit dem ersten Verbinder verbunden werden kann, wobei die Elektrolumineszenzdiode und die Photodiode zu beiden Seiten des Aufnahmeraums angeordnet sind, wobei das Verarbeitungsmodul ausgebildet ist, der Elektrolumineszenzdiode (12) einen Versorgungsstrom zu liefern, sodass diese ein Lichtsignal, das ausgesendet wird, erzeugt, um ein elektrisches Detektionssignal zu erfassen, das von der Photodiode (13) erzeugt wird und repräsentativ für ein von der Photodiode empfangenes Lichtsignal ist, und um ein Vorhandensein oder Nichtvorhandensein des zweiten Verbinders in dem Aufnahmeraum in Abhängigkeit von dem elektrischen Detektionssignal zu detektieren.

2. Elektrisches Gerät nach Anspruch 1, bei dem die Elektrolumineszenzdiode an einem ersten Ende einer ersten Leitung (30) positioniert ist, die Photodiode an einem ersten Ende einer zweiten Leitung (31) positioniert ist, wobei die erste Leitung und die zweite Leitung Wellenleiter für das ausgesandte Lichtsignal und für das empfangene Lichtsignal bilden, wobei jede der ersten Leitung und der zweiten Leitung zu dem zweiten Teil gehören und im Bereich eines zweiten Endes in den Aufnahmeraum (25) münden.

3. Elektrisches Gerät nach Anspruch 2, bei dem die erste Leitung und die zweite Leitung in einem Gehäuseelement (4) des elektrischen Geräts ausgebildet sind.

4. Elektrisches Gerät nach Anspruch 3, bei dem das Gehäuseelement, die erste Leitung und die zweite Leitung durch Formgießen hergestellt sind und aus einer selben Form stammen.

5. Elektrisches Gerät nach Anspruch 2, umfassend mindestens eine Sammellinse (27), die im Bereich des zweiten Endes der ersten Leitung und/oder des zweiten Endes der zweiten Leitung positioniert ist.

6. Elektrisches Gerät nach Anspruch 2, bei dem die Längen der ersten Leitung und der zweiten Leitung definiert sind, um ein bestimmtes elektrisches Isolationsniveau zwischen dem ersten Teil und dem zweiten Teil zu gewährleisten.

7. Elektrisches Gerät nach einem der vorhergehenden Ansprüche, bei dem das ausgesandte Lichtsignal eine Signatur umfasst, die ermöglicht, es von einem Störlichtsignal zu unterscheiden, das von einer Quelle außerhalb des elektrischen Geräts ausgesandt werden kann.

8. Elektrisches Gerät nach Anspruch 7, bei dem die Signatur darin besteht, das ausgesandte Lichtsignal zu zerhacken.

9. Elektrisches Gerät nach einem der vorhergehenden Ansprüche, ferner umfassend eine interne Antenne (11), ein Radiofrequenz-Kommunikationsmodul (9) und eine Schaltkomponente (10), die sich in dem ersten Teil befinden, wobei die Schaltkomponente einen Eingang (E) hat, der mit dem Radiofrequenz-Kommunikationsmodul verbunden ist, einen ersten Ausgang (S1), der mit der internen Antenne verbunden ist, und einen zweiten Ausgang (S2), der mit dem ersten Verbinder (20) verbunden ist, wobei das Verarbeitungsmodul ausgebildet ist, den Eingang mit dem ersten Ausgang zu verbinden, wenn das Nichtvorhandensein des zweiten Verbinders in dem Aufnahmeraum detektiert wird, und um den Eingang mit dem zweiten Ausgang zu verbinden, wenn das Vorhandensein des zweiten Verbinders in dem Aufnahmeraum detektiert wird.

10. Elektrisches Gerät nach einem der vorhergehenden Ansprüche, wobei das elektrische Gerät ein Strom-, Wasser- oder Gaszähler ist.

11. System, umfassend ein elektrisches Gerät nach einem der vorhergehenden Ansprüche, eine externe Antenne und ein Kabel, das an einem ersten Ende mit dem zweiten Verbinder versehen ist, der mit dem ersten Verbinder verbunden ist, und an einem zweiten Ende mit der externen Antenne.

12. Konfigurationsverfahren, das in einem elektrischen Gerät nach Anspruch 9 durchgeführt wird, wobei das Konfigurationsverfahren die Schritte umfasst:
- Aussenden des Lichtsignals, das ausgesandt wird;
- Erfassen des elektrischen Detektionssignals;
- wenn ein Nichtvorhandensein des zweiten Verbinders detektiert wird, Verbinden des Eingangs der Schaltkomponente mit dem ersten Ausgang der Schaltkomponente;
- wenn ein Vorhandensein des zweiten Verbinders detektiert wird, Verbinden des Eingangs der Schaltkomponente mit dem zweiten Ausgang der Schaltkomponente.

13. Computerprogramm, umfassend Anweisungen zum Durchführen des Konfigurationsverfahrens nach Anspruch 12 mittels eines Mikrocontrollers eines elektrischen Geräts.

14. Speichermittel, die **dadurch gekennzeichnet sind, dass** sie ein Computerprogramm speichern, das Anweisungen zum Durchführen des Konfigurationsverfahrens nach Anspruch 12 mittels eines Mikrocontrollers des elektrischen Geräts umfassen.

## Claims

1. Electrical equipment comprising a first portion and a second portion electrically isolated from the first portion, the first portion comprising a front-end component (10), a light-emitting diode (LED - 12), a photodiode (13), and a processor module (15), the second portion comprising a first connector (20) connected to the front-end component while being electrically isolated therefrom, a reception space (25) extending facing the first connector and being arranged to receive a second connector suitable for connecting to the first connector, the light-emitting diode and the photodiode being arranged on either side of the reception space, the processor module being arranged to supply power to the LED (12) so that it emits a light signal, to acquire an electrical detection signal that is produced by the photodiode (13) and that is representative of a light signal received by the photodiode, and to detect the second connector being present in or absent from the reception space as a function of the electrical detection signal.

2. Electrical equipment according to claim 1, wherein the LED is positioned at a first end of a first duct (30), the photodiode is positioned at a first end of a second duct (31), the first and second ducts forming waveguides for the emitted light signal and for the received light signal, each of the first and second ducts forming part of the second portion and having a respective second end opening out into the reception space (25).

3. Electrical equipment according to claim 2, wherein the first and second ducts are made in an element of a housing (4) of the electrical equipment.

4. Electrical equipment according to claim 3, wherein the element of the housing, and the first and second ducts are made by molding and come from a single mold.

5. Electrical equipment according to claim 2, including at least one converging lens (27) positioned at the second end of the first duct and/or at the second end of the second duct.

6. Electrical equipment according to claim 2, wherein the first and second ducts present lengths that are defined to provide a certain level of electrical isolation between the first and second portions.

7. Electrical equipment according to any preceding claim, wherein the emitted light signal includes a signature enabling it to be distinguished from an interfering light signal that might be emitted by a source external to the electrical equipment.

8. Electrical equipment according to claim 7, wherein the signature consists in chopping the emitted light signal.

9. Electrical equipment according to any preceding claim, further comprising an internal antenna (11), an RF communication module (9), and a switch component (10) situated in the first portion, the switch component having an input (E) connected to the RF communication module, a first output (S1) connected to the internal antenna, and a second output (S2) connected to the first connector (20), the processor module being arranged to connect the input to the first output when the second connector is detected as being absent from the reception space, and to connect the input to the second output when the second connector is detected as being present in the reception space.

10. Electrical equipment according to any preceding claim, the electrical equipment being an electricity, water, or gas meter.

11. A system including electrical equipment according to any preceding claim, an external antenna, and a cable provided at a first end with the second connector connected to the first connector, and at a second end with the external antenna.

12. A configuration method performed in electrical equipment according to claim 9, the configuration method comprising the steps of:
· emitting the light signal;
· acquiring the electrical detection signal;
· if the second connector is detected as being absent, connecting the input of the switch component to the first output of the switch component;
· if the second connector is detected as being present, connecting the input of the switch component to the second output of the switch component.

13. A computer program comprising instructions for enabling a microcontroller of electrical equipment to perform the configuration method according to claim 12.

14. Storage means **characterized in that** they store a computer program comprising instructions for enabling a microcontroller of electrical equipment to perform the configuration method according to claim 12.
